(19) Europäisches Patentamt
European Patent Office
Office européen des brevets

(11) **EP 0 791 834 B1**

(12) **EUROPÄISCHE PATENTSCHRIFT**

(45) Veröffentlichungstag und Bekanntmachung des Hinweises auf die Patenterteilung:
**06.05.2004 Patentblatt 2004/19**

(51) Int Cl.$^7$: **G01R 27/14**, B60R 21/00

(21) Anmeldenummer: **97101659.7**

(22) Anmeldetag: **04.02.1997**

(54) **Verfahren zur Bestimmung des Widerstandswertes einer Widerstandsanordnung**

Method of determining the resistance value of a resistive device

Procédé de détermination de la résistance d'un appareil résistif

(84) Benannte Vertragsstaaten:
**DE ES FR GB IT SE**

(30) Priorität: **22.02.1996 DE 19606526**

(43) Veröffentlichungstag der Anmeldung:
**27.08.1997 Patentblatt 1997/35**

(73) Patentinhaber: **Conti Temic Microelectronic GmbH**
**90411 Nürnberg (DE)**

(72) Erfinder:
• **Fendt, Günter**
**86529 Schrobenhausen (DE)**

• **Hora, Peter**
**86529 Schrobenhausen (DE)**

(56) Entgegenhaltungen:
EP-A- 0 689 058       EP-A- 0 701 928
EP-A- 0 752 592       DE-C- 4 237 072
DE-C- 4 406 897

• **PATENT ABSTRACTS OF JAPAN vol. 013, no. 087 (P-835), 28. Februar 1989 & JP 63 269069 A (HIOKI DENKI KK), 7. November 1988**

## Beschreibung

Die Erfindung bezieht sich auf ein Verfahren zur Bestimmung des widerstandswertes einer Widerstandsanordnung, auf eine Schaltungsanordnung zur Durchführung dieses Verfahrens sowie deren Verwendung zur Bestimmung des Widerstandswertes einer Sensormatte zur sitzbelegungserkennung in einem Kraftfahrzeug.

Hohe Anforderungen bezüglich Sicherheit und Zuverlässigkeit werden an eine Kraftfahrzeug-Elektronik besonders dann gestellt, wenn es sich um insassenschutzsysteme wie Gurtstraffer, Airbags, Überrollsysteme etc. handelt. Eine Forderung für Beifahrer-Airbags lautet, daß die Airbags nur dann ausgelöst werden dürfen, wenn der betreffende sitz auch tatsächlich mit einer Person besetzt ist. Hierzu müssen die Ausgangssignale einer schaltungsanordnung zur Sitzbelegungserkennung zuverlässig an eine Airbagsteuereinheit übertragen werden, da davon das Auslösen oder Nichtauslösen der Beifahrerairbags bei einem Unfall abhängt.

Eine Schaltungsanordnung und ein Verfahren zur Bestimmung des Widerstandswertes des Sitzbelegungssensors ist aus DE 4 406 897 C1 bekannt. Ein Verfahren und eine Schaltungsanordnung zum über wachen eines Schaltungspunktes auf einen Leckwiderstand ist aus EP 0 689 058 A2 bekannt.

Nach dem **Stand der Technik** handelt es sich bei einer heute üblichen Sensormatte, wie beispielsweise in der deutschen Patentschrift DE 42 37 072 C1 beschrieben, um eine Einrichtung, die in Abhängigkeit von "besetzt" und "nicht besetzt" einen Ausgangswiderstand bei einer ersten Ausführung um rund 500 kOhm bzw. 50 kOhm bei einer Variante liefert.

Diese Information ist leicht zu stören, beispielsweise durch Leckwiderstände, wie sie in oder an einem feuchten steckerbereich auftreten. Solche Leckwiderstände, die im 100 kOhm-Bereich liegen, verfälschen beim Stand der Technik immer wieder die Ergebnisse. Dies hat dazu geführt, daß die Widerstandsinformationen an eine separate Auswerteelektronik mit wasserdichtem Stecker zu einer speziellen Signalaufbereitung gegeben werden müssen.

Nachteilig hierbei ist, daß die Wirtschaftlichkeit der sicherheitskritischen Systeme und deren diverse Sensoren durch solche zusätzlichen Einrichtungen sehr belastet wird und daß außerdem Raum-, Material-, Montage- und Gewichtsaufwand sich nicht unerheblich erhöhen.

Der Erfindung liegt deshalb die **Aufgabe** zugrunde, eine Lösung aufzuzeigen, die das Verarbeiten solcher störanfälliger Informationen direkt vom Airbagsteuergerät selbst sicher und zuverlässig ermöglicht, ohne daß ein wasserdichter Stecker oder ähnliches verwendet werden muß.

Diese Aufgabe wird **gelöst** durch ein Verfahren zur Bestimmung des Widerstandswertes einer Widerstandsanordnung, bestehend aus wenigstens einer Widerstandszone mit jeweils einem veränderbaren Widerstand mit Zuleitungen, wobei die Zuleitungen jeweils auf Anschlußkontakte geführt sind. Das erfindungsgemäße Verfahren weist folgende Verfahrensschritte auf:

a) Bestimmung eines Leckstromes mittels

a1) Anlegen von Spannungspotentialen gleicher Größe an die Anschlußkontakte,
a2) Messung der an den Anschlußkontakten sich gegenüber dem Bezugspotential einstellenden Spannungen und Auswertung des Wertes dieser Spannungen im Hinblick auf zu starke Abweichung voneinander,
a3) Messung eines an einem der Anschlußkontakte auftretenden Leckstromes und Auswertung des Wertes dieses Stromes,

b) Messung der zur Bestimmung des Widerstandswertes erforderlichen Größen durch

b1) Anlegen eines ersten und zweiten Spannungspotentials an die Anschlußkontakte mit unterschiedlicher Potentialhöhe zur Erzeugung eines durch den Widerstand fließenden Prüfstromes, wobei diese Spannungspotentiale so gewählt sind, daß die Stromrichtung des Prüfstromes mit der Stromrichtung des Leckstromes übereinstimmt,
b2) Messung der an den Anschlußkontakten sich einstellenden Klemmenspannung,
b3) Messung des Prüfstromes und

c) Berechnung des Widerstandswertes mit Hilfe der gemessenen Werte für Leckstrom, Prüfstrom und Klemmenspannung.

Die **Vorteile der Erfindung** liegen insbesondere darin, daß eine separate, nach dem Stand der Technik zusätzliche Auswerteelektronik zur Signalaufbereitung nicht erforderlich ist. Außerdem entfällt ein zur Vermeidung von Leckwiderständen in den Zuleitung zur Sitzbelegungserkennung notwendiger wasserdichter Stecker. Die Wirtschaftlichkeit in der Kfz-Elektronik wird durch das vorgeschlagene Verfahren und die erfindungsgemäße Vorrichtung hierfür erheblich gesteigert.

In den unteransprüchen sind Ausgestaltungen und Weiterbildungen angegeben.

Bei einer besonders bevorzugten Ausführungsform werden Spannungspotentiale verwendet, die sich vom Bezugspotential unterscheiden. Dadurch wird erreicht, daß die möglicherweise auftretenden Leckströme immer die gleiche Stromrichtung aufweisen und damit die Auswertung wesentlich erleichtert wird.

im folgenden soll das erfindungsgemäße Verfahren und die erfindungsgemäße Anordnung anhand eines **Ausführungsbeispiels** erläutert und in den Figuren der Zeichnungen dargestellt werden.

Es zeigen

Fig. 1a: ein Flußdiagramm des prinzipellen Meß- und Prüfablaufs,

Fig. 1b: ein Flußdiagramm des gesamten Meß- und Prüfablaufs für eine sensormatte mit zwei widerstandszonen,

Fig. 2: ein zum Meß- und Prüfablauf zugehöriges Prinzipschaltbild der erfindungsgemäßen Meß- und Widerstandsanordnung in einem ersten zustand (Ruhezustand),

Fig. 3: das Prinzipschaltbild der Fig. 2 in einem zweiten Zustand,

Fig. 4: das Prinzipschaltbild der Fig. 2 in einem dritten Zustand,

Fig. 5: das Prinzipschaltbild der Fig. 2 in einem vierten Zustand,

Fig. 6: das Prinzipschaltbild der Fig. 2 in einem fünften Zustand,

Fig. 7: das Prinzipschaltbild der Fig. 2 in einem sechsten zustand.

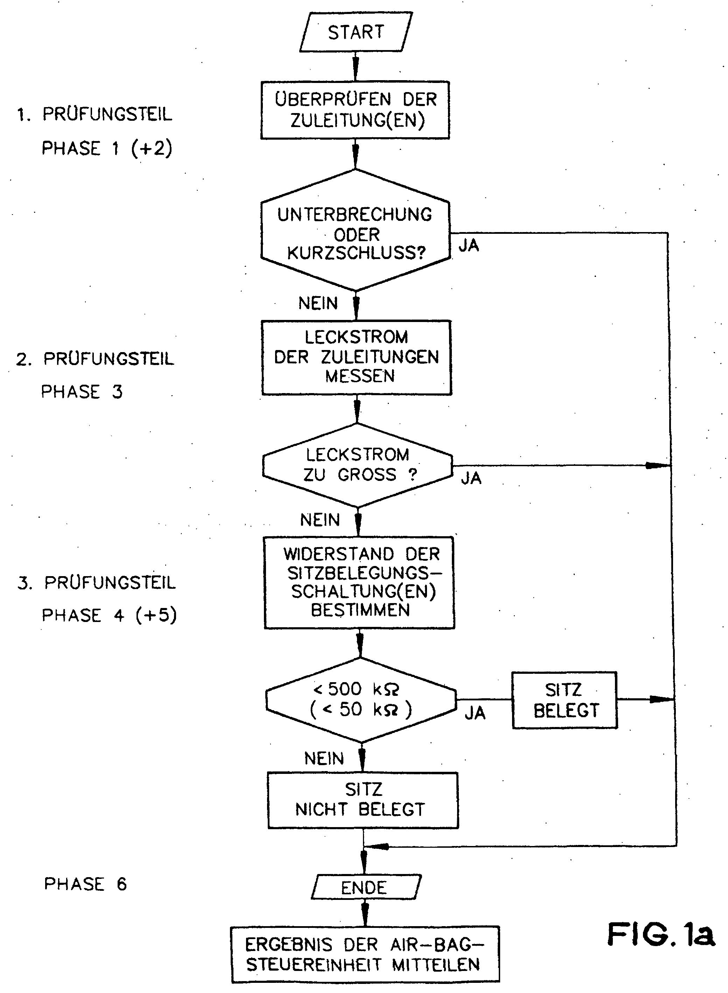

In **Fig. 1a** ist ein Flußdiagramm des prinzipiellen, dreiteiligen und aus insgesamt sechs Phasen bestehenden Meß- und Prüfablaufs, sowohl für eine Ein-Zonen-Sitzbelegungserkennung als auch für eine Zwei-Zonen-Sitzbelegungserkennung, dargestellt. **Tabelle 1** zeigt einen Überblick über die insgesamt sechs Phasen des Meß- und Prüfablaufs. Die Phasen 1 und 2 stellen den ersten Prüfungsteil dar, Phase 3 den zweiten und die Phasen 4 und 5 den dritten Prüfungsteil. Mit Phase 6 wird der Prüfvorgang beendet.

Tabelle 1

| Phase | Prüfinhalt | Eine Widerstandszone | zwei Widerstandszonen |
|---|---|---|---|
| 1 | Zuleitungen 3a, 3b zur Widerstandszone 5a überprüfen | x | x |
| 2 | Zuleitungen 3c, 3d zur Widerstandszone 5b überprüfen | - | x |
| 3 | Messung des Leckstroms | x | x |
| 4 | Widerstand R1 der Widerstandszone 5a ermitteln | x | x |
| 5 | Widerstand R2 der Widerstandszone 5b ermitteln | - | x |
| 6 | Prüfvorgang beenden | x | x |

Zur Durchführung des Meß- und Prüfablaufs nehmen spannungsgesteuerte Stromquellen **A, B** und **C**, spannungsgesteuerte Stromsenken **B'** und **C'** und ein Transistor **T$_1$** sechs verschiedene Zustände ein, die in **Tabelle 2** zusammengestellt sind.

| Zu-stand | spannungsgesteuerte Strom- quelle A | quelle B senke B' | quelle C senke C' | Transistor T$_1$ | Zweck |
|---|---|---|---|---|---|
| 1 | passiv | passiv | passiv | passiv | Prüfvorgang inaktiv |
| 2 | passiv | 20 V | passiv | aktiv | Zuleitungen 3a und 3b zur Widerstands- zone 5a überprüfen |
| 3 | passiv | passiv | 20 V | aktiv | Zuleitungen 3c und 3d zur Widerstands- zone 5b überprüfen |
| 4 | 20 V | 20 V | 20 V | passiv | Messung des Leck- stromes |
| 5 | 20 V | 15 V | 20 V | passiv | Widerstand R1 der Widerstandszone 5a ermitteln |
| 6 | 20 V | 20 V | 15 V | passiv | Widerstand R2 der Widerstandszone 5b ermitteln |

**Tabelle 2**

"Passiv" bedeutet, daß die betreffende spannungsgesteuerte Stromquelle **A, B** oder **C**, die betreffende spannungsgesteuerte Stromsenke **B'** oder **C'** nicht angesteuert wird, oder der Transistor **T$_1$** sperrt; andernfalls ist für die spannungsgesteuerten Stromquellen **A, B** und **C** und -senken **B'** und **C'** die zutreffende Steuerspannung angegeben. "Aktiv" für den Transistor **T$_1$** bedeutet, daß der Transistor **T$_1$** mittels einer positiven Basisspannung leitend geschaltet ist und über seine Emitter-Kollektorstrecke ein Strom fließt.

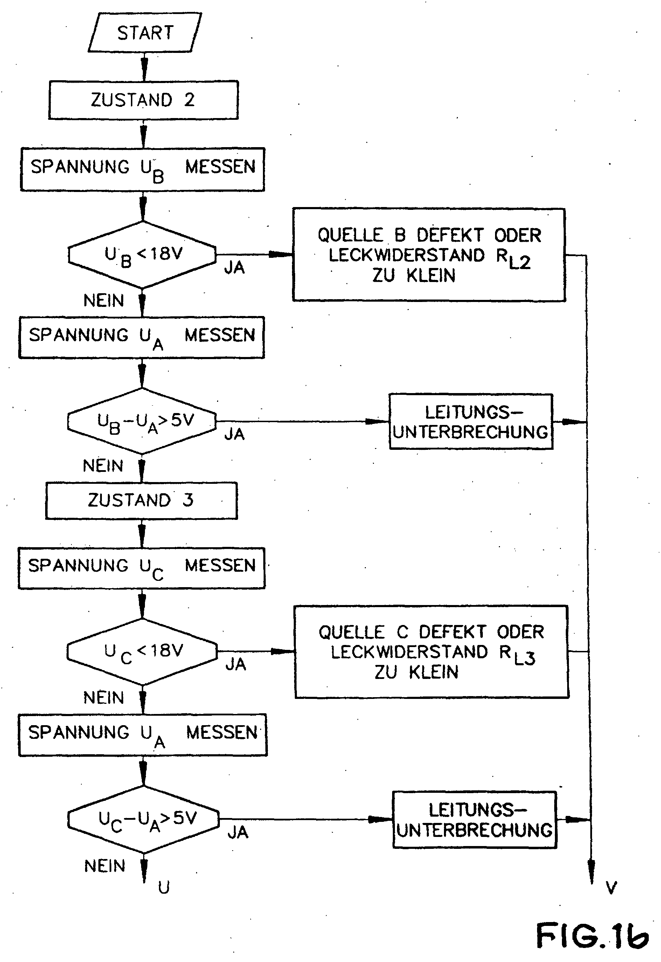

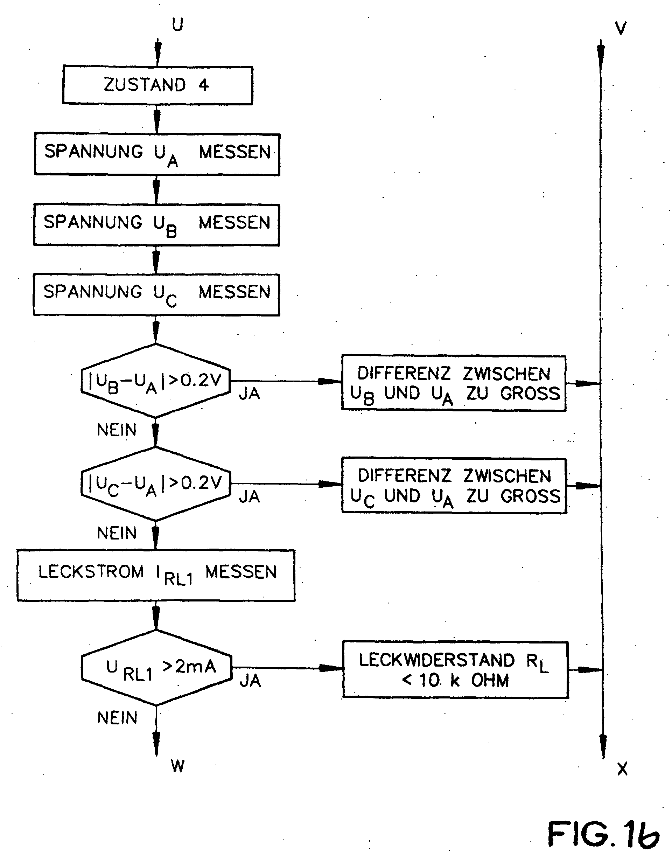

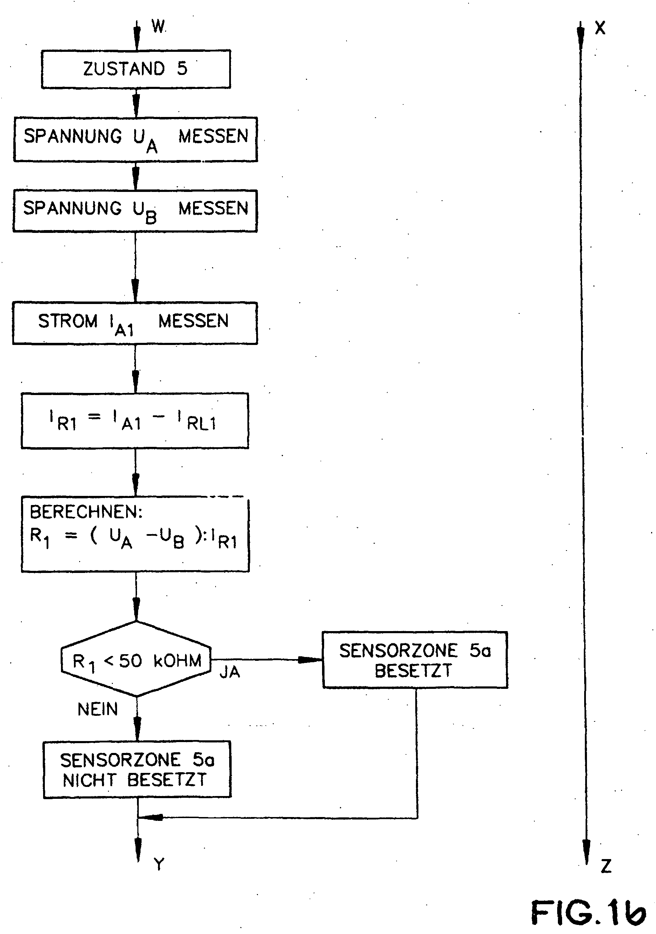

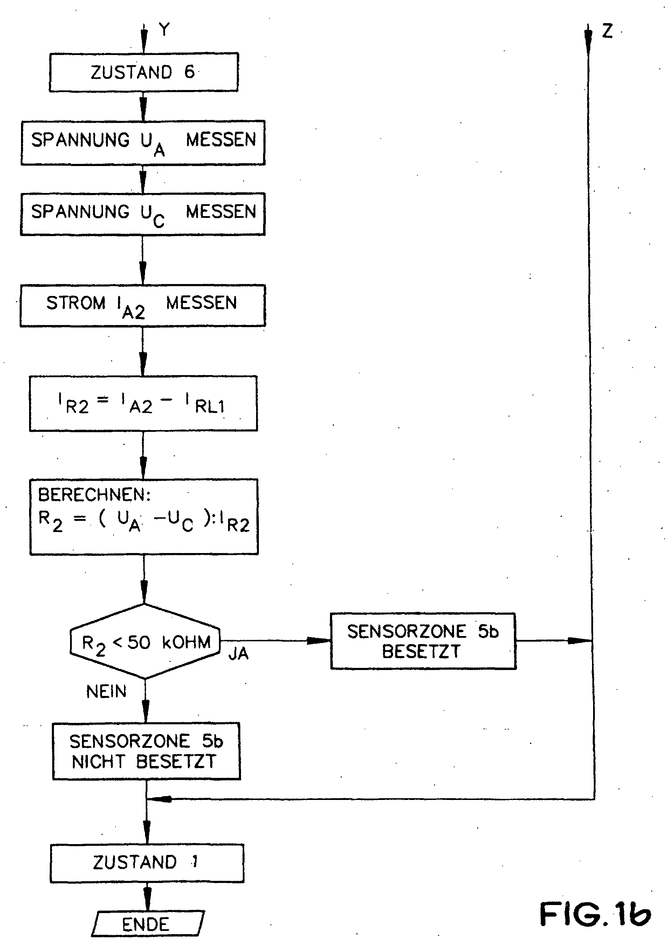

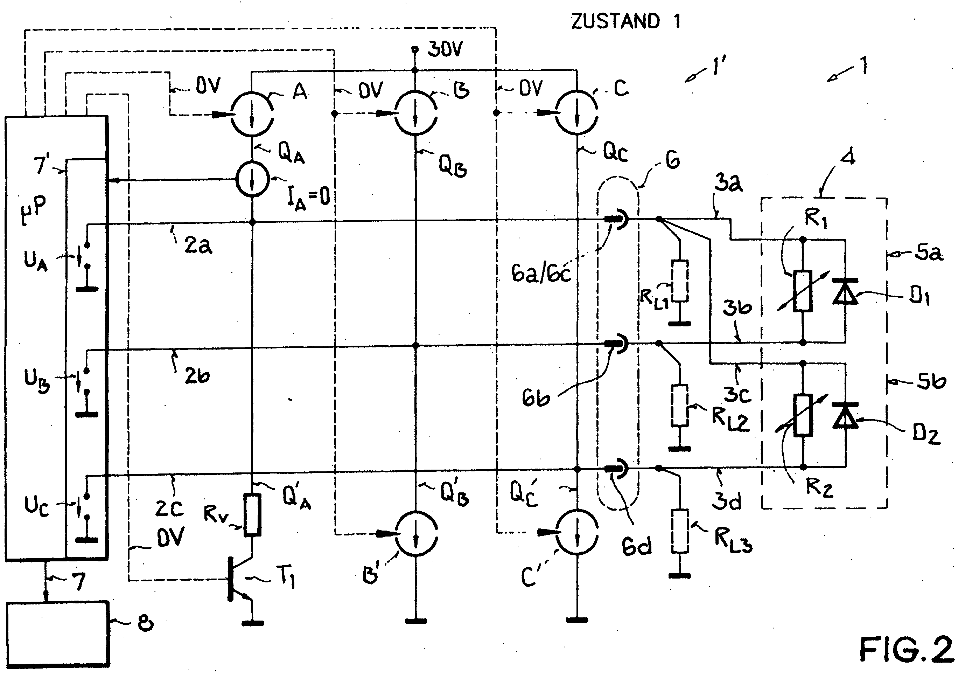

In **Fig. 1b** ist anhand eines Flußdiagramms der gesamte Meß- und Prüfablauf für eine Sensormatte mit zwei Widerstandszonen dargestellt. Während eines gesamten Meß- und Prüfablaufs innerhalb einer Zyklusdauer von 500 ms nimmt eine Schaltungsanordnung **1** (Fig. 2 bis 7) alle in Tabelle 2 dargestellten Zustände 1 bis 6 ein, um Zuleitungen auf Kurzschluß oder unterbrechung zu überprüfen, um einen gegebenenfalls vorhandenen Leckstrom in den Zuleitungen zu messen und um den Zustand (besetzt oder unbesetzt) der Widerstandszonen zu ermitteln. Alle im Flußdiagramm enthaltenen Angaben, Schwellen und Größen werden in der nachfolgenden Beschreibung erklärt.

Die **Fig. 2** bis **7** zeigen eine Schaltungsanordnung **1** zur Durchführung des in Fig. 1b dargestellten Meß- und Prüfablaufs, bestehend aus einer Widerstandsanordnung **4** zur Sitzbelegungserkennung und einer Meßanordnung **1'** zur Auswertung der Widerstandsanordnung **4**, wobei jede der in den Fig. 2 bis 7 skizzierte Schaltungsanordnung **1** einen der in Tabelle 2 beschriebenen Zustand zeigt.

Bei der Widerstandsanordnung **4** handelt es sich um eine bekannte und deshalb nicht näher beschriebene Sensormatte, die sich aus einer ersten Widerstandszone **5a** und eventuell einer zweiten Widerstandszone **5b** (bei einer verbesserten Ausführungsform) zusammensetzt.

Ein veränderbarer Widerstand **R$_1$** bzw. **R$_2$** der Widerstandszone **5a** bzw. **5b** stellt den Widerstand der Sensormatte **4** dar, dessen Größe davon abhängt, ob beispielsweise ein Sitz eines Kraftfahrzeuges belegt oder nicht belegt ist. Im Ausführungsbeispiel handelt es sich um zwei Versionen einer Sensormatte **4**, deren Widerstand weniger als 500 kOhm bzw 50 kOhm bei belegtem und mehr als 500 kOhm bzw. 50 kOhm bei nicht belegtem Kfz-Sitz beträgt.

Zur Prüfung der Sensormatte **4** auf Leitungsunterbrechung ist parallel zum Widerstand **R$_1$** bzw **R$_2$** der Widerstandszone **5a** bzw. **5b** eine Diode **D$_1$** bzw. **D$_2$** geschaltet. Die Sensormatte **4** ist mit der Meßanordnung **1'** mittels Zuleitungen **3a, 3b, 3c** und **3d**, die sich vorzugsweise innerhalb einer steckereinheit **6** mit Anschlußkontakten **6a/6c, 6b** und **6d** befinden, verbunden. um eine Zuleitung einzusparen, sind die beiden Zuleitungen **3a** und **3c** miteinander verbunden.

Mit **R$_{L1}$, R$_{L2}$** und **R$_{L3}$** sind Leckwiderstände der Zuleitungen **3a, 3b, 3c** und **3d** oder der Anschlußkontakte **6a/6c, 6b** und **6d** der Steckereinheit **6** angedeutet. In den Schaltbildern der **Fig. 2** bis **7** sind die Leckwiderstände **R$_{L1}$, R$_{L2}$** und **R$_{L3}$** nach Masse hin eingezeichnet; sie sind auch nach der Batteriespannung hin denkbar.

Mit **A, B** und **C** sind schaltbare und spannungsgesteuerte (spannungsabhängige) Stromquellen angedeutet, mit **B'** und **C'** schaltbare und spannungsgesteuerte (spannungsabhängige) Stromsenken. Hierbei ist die Stromquelle **B** mit einer Zuleitung **2b** und der Stromsenke **B'**, die Stromquelle **C** mit einer Zuleitung **2c** und der Stromsenke **C'** verbunden.

Die Stromquelle **A** ist über einen Vorwiderstand $R_V$, durch den ein Strom von maximal 2 mA fließt, an den Kollektor eines Transistors $T_1$ und an eine Zuleitung **2a** angeschlossen Der durch die spannungsgesteuerte Stromquelle **A** fließende Strom $I_A$ wird gemessen, der sich ergebende Wert in einem A/D-Umsetzer **7'** digitalisiert und einer Auswerteeinheit, vorzugsweise einem Mikroprozessor $\mu$**P**, zugeführt.

Alle drei Stromquellen **A**, **B** und **C** liegen an einer versorgungsspannung von ca. 30 V und geben einen Strom von 0 mA bis 2,5 mA ab. Die Steuerspannungen der spannungsgesteuerten Stromquellen **A, B** und **C** und der spannungsgesteuerten stromsenken **B'** und **C'** beträgt 15 V oder 20 v, je nach den Erfordernissen einer der nachstehend beschriebenen Testphasen. Durch die spannungsgesteuerten Stromquellen **A, B** und **C** und die spannungsgesteuert Stromsenken **B'** und **C'** fließt im Ausführungsbeispiel ein Strom von maximal 200 $\mu$A.

Die während der Testphasen an den Zuleitungen **2a, 2b** und **2c** auftretenden Spannungen $U_A$, $U_B$ und $U_C$ werden im A/D-Umsetzer **7'** digitalisiert und dem Mikroprozessor $\mu$**P** zur Auswertung zugeführt. Dieser Mikroprozessor $\mu$**P** führt auch während der Testphasen den Stromquellen **A, B** und **C** und den Stromsenken **B'** und **C'** die Steuerspannung von 0 V, 15 V oder 20 V zu. Bei Leitungsunterbrechung oder zu großem Leckstrom, wenn der Meß- und Prüfvorgang abgebrochen wird, wird mittels einer Verbindung **7** einer nachgeschalteten Warneinheit **8** ein Signal zugeführt, so daß zum Beispiel im Sichtbereich des Fahrers eine Warnanzeige aktiviert wird.

Die **Fig. 2** zeigt die Meß- und Widerstandsanordnung **1** im Ruhezustand, dem Zustand 1. Allen spannungsgesteuerten Stromquelle **A, B** und **C**, allen spannungsgesteuerten Stromsenken **B'** und **C'** und dem Transistor $T_1$ wird vom Mikroprozessor $\mu$**P** eine Steuerspannung von 0 V zugeführt, so daß durch die Stromquelle **A** kein Strom $I_A$ fließt und keine Spannungen $U_A$, $U_B$ und $U_C$ anliegen.

Im ersten Prüfungsteil, bestehend aus den Phasen 1 und 2, werden die Zuleitungen **3a**, **3b, 3c** und **3d** zu den Widerstandszonen **5a** und **5b** der Sensormatte **4** auf Unterbrechung und Kurzschluß gegen **Masse** oder gegen die Batteriespannung geprüft.

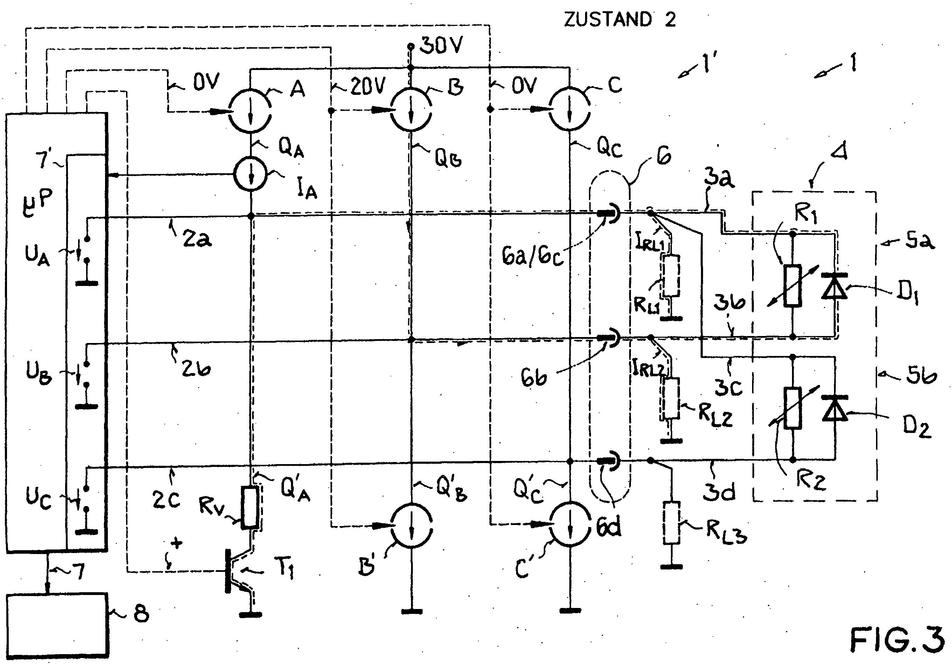

In Phase **1**, entsprechend **Fig. 3**, nehmen die spannungsgesteuerten stromquellen **A, B** und **C**, die spannungsgesteuerten Stromsenken **B'** und **C'** und der Transistor $T_1$ den Zustand 2 aus Tabelle 2 ein, was bedeutet, daß der spannungsgesteuerten Stromquelle **B** und der spannungsgesteuerten Stromsenke **B'** vom Mikroprozessor $\mu$**P** eine Steuerspannung von 20 V zugeführt werden und der Transistor $T_1$ mittels einer positiven Steuerspannung an seiner Basis leitend geschaltet wird.

Dadurch fließt ein Strom von der Stromquelle **B** über den Anschlußkontakt **6b**, die in Durchlaßrichtung geschaltete Diode $D_1$, den Anschlußkontakt **6a/6c**, den Vorwiderstand $R_V$ und die leitende Kollektor-Emitter-Strecke des Transistors $T_1$ zum Bezugspotential. Gegebenenfalls fließt ein zusätzlicher Leckstrom $I_{RL2}$ bzw. $I_{RL1}$ über den Leckwiderstand $R_{L2}$ bzw. $R_{L1}$ nach Masse ab (oder zur Versorgungsspannung hin).

Die sich an der Zuleitung **2b** einstellende Spannung $U_B$ wird dem Mikroprozessor $\mu$**P** zugeführt. Ist $U_B$ kleiner als 18 V, so ist die Konstanststromquelle **B** defekt oder es fließt ein unzulässig hoher Leckstrom $I_{RL2}$. Der Prüfvorgang wird in diesem Fall abgebrochen.

Ist $U_B$ größer oder gleich 18 V, wird die an der Zuleitung **2a** liegende Spannung $U_A$ gemessen und in der Auswerteeinheit **7** die Differenz $U_B - U_A$ gebildet. im Falle, daß diese Differenzspannung größer als 5 V ist, liegt eine Leitungsunterbrechung vor und der Prüfvorgang wird abgebrochen. Typischerweise liegt die Spannung $U_A$ im Bereich von 20 V abzüglich der an der Diode $D_1$ abfallenden Spannung.

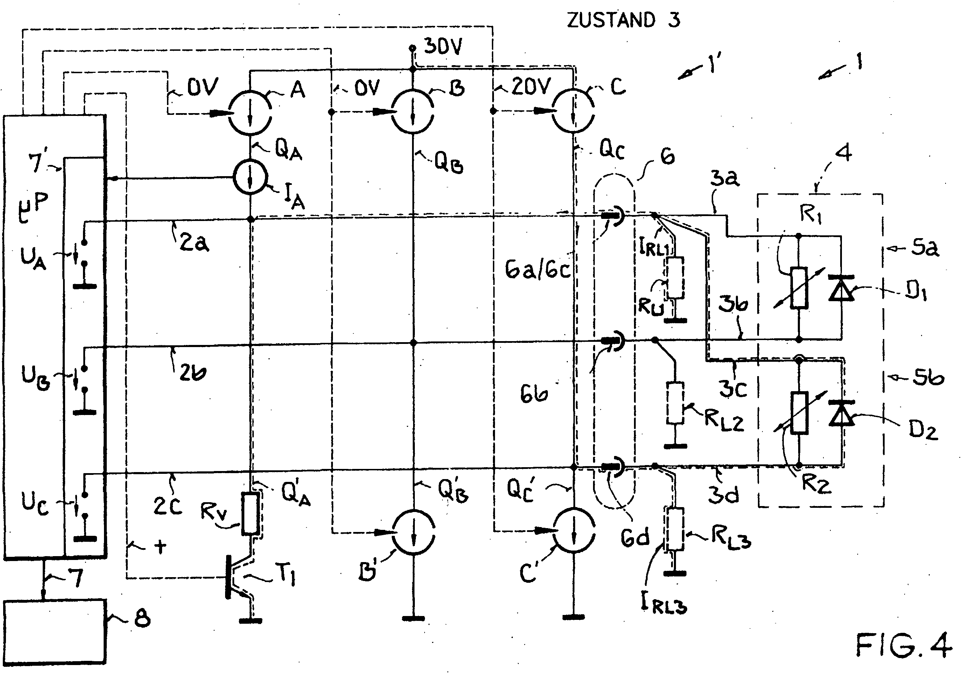

In Phase 2, entsprechend **Fig. 4**, nehmen die spannungsgesteuerten Stromquellen **A, B** und **C**, die spannungsgesteuerten Stromsenken **B'** und **C'** und der Transistor $T_1$ den Zustand 3 aus Tabelle 2 ein, was bedeutet, daß der spannungsgesteuerten Stromquelle **C** und der spannungsgesteuerten Stromsenke **C'** vom Mikroprozessor $\mu$**P** eine Steuerspannung von 20 V zugeführt werden und der Transistor $T_1$ mittels einer positiven Steuerspannung an seiner Basis leitend geschaltet wird.

Dadurch fließt ein Strom von der Stromquelle **C** über den Anschlußkontakt **6d**, die in Durchlaßrichtung geschaltete Diode $D_2$, den Anschlußkontakt **6a/6c**, den Vorwiderstand $R_V$ und die leitende Kollektor-Emitter-Strecke des Transistors $T_1$ zum Bezugspotential. Gegebenenfalls fließt ein zusätzlicher Leckstrom $I_{RL3}$ bzw. $I_{RL1}$ über den Leckwiderstand $R_{L3}$ bzw. $R_{L1}$ nach Masse ab (oder zur Versorgungsspannung hin).

Die sich an der Zuleitung **2c** einstellende Spannung $U_C$ wird dem Mikroprozessor $\mu$**P** zugeführt. Ist $U_C$ kleiner als 18 V, so ist die Konstanststromquelle **C** defekt oder es fließt ein unzulässig hoher Leckstrom $I_{RL3}$. In diesem Fall wird der Prüfvorgang abgebrochen.

Ist $U_C$ größer oder gleich 18 V, wird die an der Zuleitung **2a** liegende Spannung $U_A$ gemessen und in der Auswerteeinheit **7** die Differenz $U_C - U_A$ gebildet. Wenn diese Differenzspannung größer als 5 V ist, so liegt eine Leitungsunterbrechung vor und der Prüfvorgang wird abgebrochen, ansonsten wird der Meß- und Prüfvorgang fortgesetzt. Typischerweise liegt die Spannung $U_C$ im Bereich von 20 V abzüglich der an der Diode $D_2$ abfallenden Spannung.

wenn es sich um eine Ein-Zonen-Sitzbelegungserkennung handelt, entfällt Phase 2 bzw. der Zustand 3 aus Tabelle 2. Wird eine Unterbrechung oder ein zu niederohmiger Anliegeschluß ermittelt, wird zur Phase 6 verzweigt und der Meß- und Prüfablauf somit abgebrochen. Hierzu nehmen die Stromquellen **A, B** und **C**, die Stromsenken **B'** und **C'** und der Transistor $T_1$ den Zustand 1 aus Tabelle 2 ein, was dem Ruhezustand entspricht.

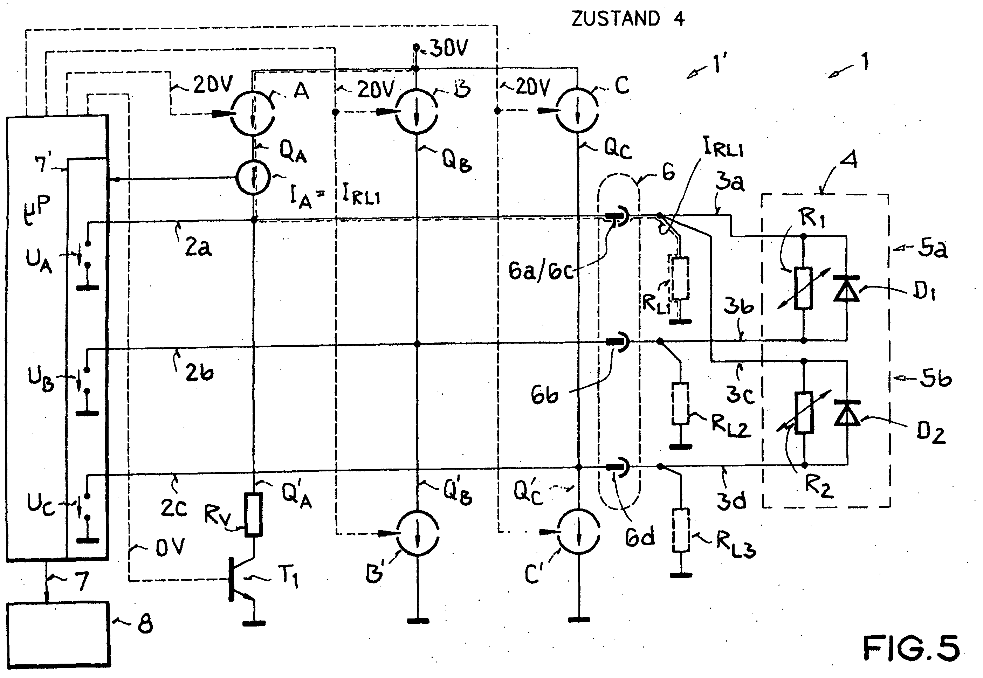

Im zweiten Prüfungsteil, entsprechend der Phase 3, wird ein eventuell vorhandener Leckstrom $I_{RL1}$ in der Zuleitung **2a, 3a** oder im Anschlußkontakt **6a/6c** der Steckereinheit **6** bestimmt, wozu die Stromquellen **A, B** und **C**, die Stromsenken **B'** und **C'** und der Transistor **T$_1$** den in **Fig. 5** dargestellten Zustand 4 aus Tabelle 2 einnehmen.

Die an den Zuleitungen **2a, 2b** und **2c** liegenden Spannungen $U_A$, $U_B$ und $U_C$ werden gemessen und die Meßwerte der Auswerteeinheit **7** zugeführt, in der zuerst die spannungsdifferenz $U_B - U_A$ berechnet wird. Übersteigt diese Spannungsdifferenz betragsmäßig einen Wert von 0,2 V, so weichen die Spannungen $U_A$ und $U_B$ zu stark voneinander ab. Der Prüfvorgang wird in diesem Fall abgebrochen, da vorhandene Leckströme zu groß sind.

Anschließend wird in der Auswerteeinheit **7** die Spannungsdifferenz $U_C - U_A$ errechnet und der Prüfvorgang abgebrochen, falls diese Spannungsdifferenz betragsmäßig die Schwelle von 0,2 V übersteigt.

Ansonsten wird der aus der Stromquelle **A** fließende Strom $I_A$, der dem Leckstrom $I_{RL1}$ entspricht, gemessen und der Meßwert der Auswerteeinheit **7** zugeführt.

Fließt ein Leckstrom $I_{RL1}$ größer als 2 mA, d.h. ist der ermittelte Leckwiderstand $R_{L1}$ kleiner als 10 kohm, wird der Meß- und Prüfablauf wegen eines zu großen Leckstroms $I_{RL1}$ durch Verzweigung zur Phase 6 abgebrochen.

Im dritten Prüfungsteil, bestehend aus den Phasen 4 und 5, wird die Größe der Widerstände $R_1$ bzw. $R_2$ der Widerstandszonen **5a** bzw. **5b** bestimmt und somit entschieden, ob der Sitz belegt oder nicht belegt ist. Dazu werden von den Stromquellen **A, B** und **C**, den Stromsenken **B'** und **C'** und dem Transistor **T$_1$** nacheinander die Zustände 5 und 6 aus Tabelle 2 eingenommen.

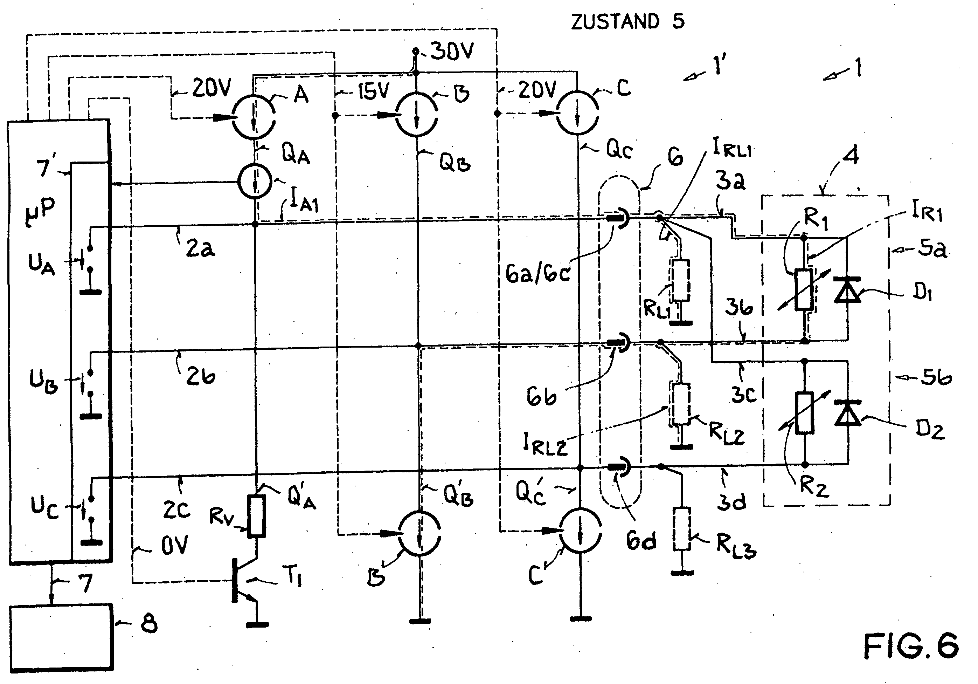

In Phase 4 gemäß Zustand 5 und **Fig. 6** fließt ein Strom $I_{A1}$ von der Stromquelle **A** über den Anschlußkontakt **6a/6c**, den veränderbaren Widerstand $R_1$, den Anschlußkontakt **6b**, die Stromsenke **B'** zum Bezugspotential. Gegebenenfalls fließen zusätzlich Leckströme $I_{RL1}$ ($I_{RL1}$ wurde in Phase 3 bestimmt) und/oder $I_{RL2}$ über die Leckwiderstände $R_{L1}$ bzw. $R_{L2}$ nach Masse ab (oder zur Versorgungsspannung hin), die aber aufgrund der Berechnungsmethode keinen Einfluß auf die Berechnung des Widerstandes $R_1$ haben.

Die an den Zuleitungen **2a** bzw. **2b** liegenden Spannungen $U_A$ bzw. $U_B$ und der aus der Stromquelle **A** fließende Strom $I_{A1}$ werden gemessen und die Meßwerte der Auswerteeinheit **7** zugeführt. Der Widerstand $R_1$ der Widerstandszone **5a** berechnet sich dann nach der Gleichung:

$$R_1 = (U_A - U_B) : I_{R1} \text{ mit } I_{R1} = I_{A1} - I_{RL1}.$$

Ergibt sich für den Widerstand $R_1$ ein Wert kleiner als 50 kOhm, so ist die Widerstandszone **5a** besetzt; ein Wert größer oder gleich 50 kOhm bedeutet, daß die Widerstandszone **5a** nicht besetzt ist.

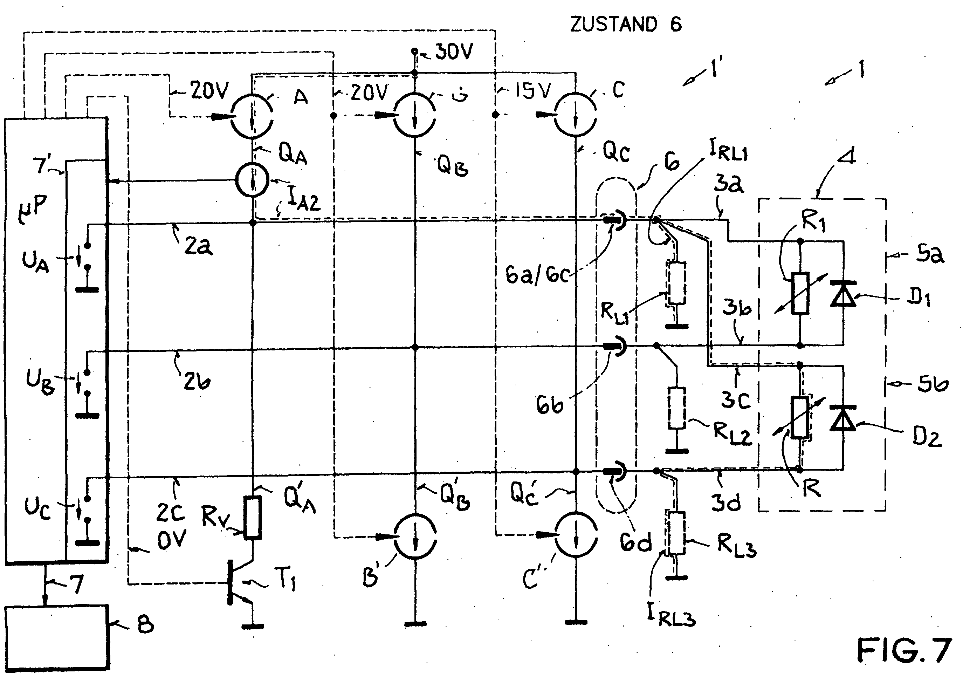

In Phase 5 gemäß Zustand 6 und **Fig. 7** fließt ein Strom $I_{A2}$ von der Stromquelle **A** über den Anschlußkontakt **6a/6c**, den veränderbaren Widerstand $R_2$, den Anschlußkontakt **6d**, die Stromsenke **C'** zum Bezugspotential. Gegebenenfalls fließen zusätzlich Leckströme $I_{RL1}$ ($I_{RL1}$ wurde in Phase 3 bestimmt) und/oder $I_{RL3}$ über die Leckwiderstände $R_{L1}$ und $R_{L3}$ nach Masse ab (oder zur Versorgungsspannung hin), die aber aufgrund der Berechnungsmethode keinen Einfluß auf die Berechnung des Widerstandes $R_2$ haben.

Die an den Zuleitungen **2a** bzw. **2c** liegenden Spannungen $U_A$ bzw. $U_C$ und der aus der Stromquelle **A** fließende Strom $I_{A2}$ werden gemessen und die Meßwerte der Auswerteeinheit **7** zugeführt. Der Widerstand $R_2$ der Widerstandszone **5b** berechnet sich dann nach der Gleichung:

$$R_2 = (U_A - U_C) : I_{R2} \text{ mit } I_{R2} = I_{A2} - I_{RL1}.$$

Ergibt sich für den Widerstand $R_2$ ein Wert kleiner als 50 kOhm, so ist die Widerstandszone **5b** besetzt; ein Wert größer oder gleich 50 kOhm bedeutet, daß die Widerstandszone **5b** nicht besetzt ist.

Handelt es sich lediglich um eine Ein-Zonen-Sitzbelegungserkennung, entfällt Phase 5 bzw. wird der Zustand 6 der Tabelle 2 von den Stromquellen **A**, **B** und **C**, den Stromsenken **B'** und **C'** und dem Transistor **T$_1$** nicht eingenommen.

Nach Durchlaufen des gesamten Meß- und Prüfablaufs erfolgt nach dem dritten Prüfungsteil mit Phase 6 die Beendigung des Prüfablaufs. Gemäß zustand **1** aus Tabelle **2** nehmen hierzu alle Stromquellen **A, B** und **C**, die Stromsenken **B'** und **C'** und der Transistor **T$_1$** einen passiven Zustand ein.

Das Ergebnis des Meß- und Prüfablaufs wird zur weiteren Auswertung von der Auswerteeinheit **7** einer nachgeschalteten Airbagsteuereinheit zugeführt, um den Belegungszustand des betreffenden Kraftfahrzeugsitzes zu berücksichtigen und bei einem Unfall den betreffenden Airbag nur dann auszulösen, wenn der Sitz auch tatsächlich belegt ist.

Die erfindungsgemäße Meß- und Widerstandsanordnung eignet sich vorzugsweise für eine Sitzbelegungserkennung in einem Kraftfahrzeug, gewährleistet eine einwandfreie, sichere und zuverlässige Sitzbelegungserkennung mittels einer Sensormatte, die einen Ein-Zonen-Sensor oder einen Zwei-Zonen-Sensor aufweist.

**Patentansprüche**

1. Verfahren zur Bestimmung des Widerstandswertes einer Widerstandsanordnung (**4**), bestehend aus wenigstens einer Widerstandszone (**5a; 5b**) mit jeweils einem veränderbaren Widerstand (**R$_1$; R$_2$**) mit Zuleitungen (**3a, 3b; 3c, 3d**), wobei die Zuleitungen jeweils auf Anschlußkontakte (**6a, 6b; 6c, 6d**) geführt sind, mit den **folgenden Verfahrensschritten**:

   a) Bestimmung eines Leckstromes (**I$_{RL1}$**) mittels

     a1) Anlegen von Spannungspotentialen (**Q$_A$, Q$_B$, Q$_C$, Q$_B$', Q$_C$'**) gleicher Größe an die Anschlußkontakte (**6a, 6b; 6c, 6d**),

     a2) Messung der an den Anschlußkontakten (**6a, 6b; 6c, 6d**) sich gegenüber dem Bezugspotential einstellenden Spannungen (**U$_A$, U$_B$, U$_C$**) und Auswertung des Wertes dieser Spannungen (**U$_A$, U$_B$, U$_C$**) im Hinblick auf zu starke Abweichung voneinander, a3) Messung eines an einem der Anschlußkontakte (**6a, 6b; 6c, 6d**) auftretenden Leckstromes (**I$_{RL1}$**) und Auswertung des Wertes dieses Stromes.

   b) Messung der zur Bestimmung des Widerstandswertes (**R$_1$; R$_2$**) erforderlichen Größen durch

     b1) Anlegen eines ersten und zweiten Spannungspotentials (**Q$_A$, Q$_B$; Q$_A$, Q$_C$**) an die Anschlußkontakte (**6a, 6b; 6c, 6d**) mit unterschiedlicher Potentialhöhe zur Erzeugung eines durch den Widerstand (**R$_1$; R$_2$**) fließenden Prüfstromes (**I$_{R1}$; I$_{R2}$**), wobei diese Spannungspotentiale (**Q$_A$, Q$_B$; Q$_A$, Q$_C$**) so gewählt sind, daß die Stromrichtung des Prüfstromes (**I$_{R1}$; I$_{R2}$**) mit der Stromrichtung des Leckstromes (**I$_{RL1}$**) übereinstimmt,

     b2) Messung der an den Anschlußkontakten (**6a, 6b; 6c, 6d**) sich einstellenden Klemmenspannung (**U$_A$, U$_B$; U$_A$, U$_C$**),

     b3) Messung des Prüfstromes (**I$_{A1}$; I$_{A2}$**) und

   c) Berechnung des Widerstandswertes (**R$_1$; R$_2$**) mit Hilfe der gemessenen Werte für Leckstrom (**I$_{RL1}$**), Prüfstrom (**I$_{A1}$; I$_{A2}$**) und Klemmenspannung (**U$_A$, U$_B$; U$_A$, U$_C$**).

2. Verfahren nach Anspruch 1, **dadurch gekennzeichnet, daß** vor Bestimmung des Leckstromes (**I$_{RL1}$**) eine Prüfung der Zuleitungen (**3a, 3b, 3c, 3d**) auf Leitungsunterbrechung durchgeführt wird mittels:

   a) eines den Widerstand (**R$_1$; R$_2$**) überbrückenden Gleichrichterelements (**D$_1$; D$_2$**),

   b) Erzeugen von Spannungspotentialen (**Q$_B$, Q$_A$'; Q$_C$, Q$_A$'**) an den Anschlußkontakten (**6a, 6b; 6c, 6d**) derart, daß das Gleichrichterelement (**D$_1$; D$_2$**) in Durchlaßrichtung gesteuert wird,

   c) Messung der an den Anschlußkontakten (**6a, 6b; 6c, 6d**) sich einstellenden Spannungen (**U$_A$, U$_B$; U$_A$, U$_C$**) und

   d) Auswertung der Spannungen (**U$_A$, U$_B$; U$_A$, U$_C$**) sowie deren Spannungsdifferenzen (**U$_B$ - U$_A$; U$_C$ - U$_A$**);

3. verfahren nach Anspruch 2, **dadurch gekennzeichnet, daß** der Widerstandsanordnung (**4**) eine zweite Widerstandszone (**5b**) hinzugefügt wird, deren erster Anschlußkontakt (**6c**) derart mit dem Anschlußkontakt (**6a**) der ersten Widerstandszone (**5a**) verbunden wird, daß das Gleichrichterelement (**D$_1$**) der ersten Widerstandszone (**5a**) die gleiche Anschlußrichtung aufweist wie das Gleichrichterelement (**D$_2$**) der zweiten Widerstandszone (**5b**), und an deren zweiten Anschlußkontakt (**6d**) ein weiteres Spannungspotential (**Q$_C$**) angelegt wird.

4. Verfahren nach einem der Ansprüche 1 bis 3, **dadurch gekennzeichnet, daß** vom Bezugspotential sich unterscheidende Spannungspotentiale (**O$_A$, Q$_B$, Q$_C$, Q$_A$', Q$_B$', Q$_C$'**) verwendet werden.

5. Schaltungsanordnung zur Durchführung des Verfahrens nach Anspruch 1 bis 4, mit den Merkmalen:

   a) zur Erzeugung der Spannungspotentiale (**Q$_A$, Q$_B$, Q$_C$, Q$_A$', Q$_B$', Q$_C$'**) sind spannungsgesteuerte Stromquellen (**A, B, C**), spannungsgesteuerte Stromsenken (**B', C'**) und ein Transistor (**T$_1$**) mit Vorwiderstand (**R$_V$**) vorhanden,

b) zur Steuerung der spannungsgesteuerten Strornquellen (**A, B, C**) und Stromsenken (**B', C'**) und des Transistors (**T$_1$**) ist ein Mikroprozessor mit einem Programm zur Durchführung des Verfahrens nach Anspruch 1 ($\mu$**P**) vorhanden und

c) zur Digitalisierung der gemessenen Spannungen (**U$_A$, U$_B$, U$_C$**) und Ströme (**I$_A$, I$_{A1}$, I$_{A2}$**) und Weitergabe der digitalisierten Meßwerte an den Mikroprozessor ($\mu$**P**) ist ein A/D-Umsetzer (**7'**) vorhanden.

6. Verwendung der Schaltungsanordnung nach Anspruch 5 zur Bestimmung des Widerstandswertes einer Sensormatte (**4**) zur Sitzbelegungserkennung in einem Kraftfahrzeug.

**Claims**

1. A method for the determination of the resistance value of a resistive device (**4**) consisting of at least one resistance zone (**5a; 5b**) incorporating, in each case, a variable resistance (**R$_1$; R$_2$**) and leads (**3a, 3b; 3c, 3d**), wherein the leads are led to respective terminal contacts (**6a, 6b; 6c, 6d**), the method comprising the following method steps

   a) the determination of a leakage current (**I$_{RL1}$**) by means of

      a1) the application of voltage potentials (**Q$_A$, Q$_B$, Q$_C$, Q$_B$', Q$_C$'**) of the same magnitude to the terminal contacts (**6a, 6b; 6c, 6d**),

      a2) measurement of the voltages (**U$_A$, U$_B$, U$_C$**) appearing on the terminal contacts (**6a, 6b; 6c, 6d**) with respect to the reference potential and evaluation of the value of these voltages (**U$_A$, U$_B$, U$_C$**) in regard to too large a deviation from one another,

      a3) measurement of a leakage current (**I$_{RL1}$**) occurring on one of the terminal contacts (**6a, 6b; 6c, 6d**) and evaluation of the value of this current,

   b) measuring the magnitudes required for the determination of the resistance value (**R$_1$; R$_2$**) by

      b1) application of a first and a second voltage potential (**Q$_A$, Q$_B$: Q$_A$, Q$_C$**) of different potential levels to the terminal contacts (**6a, 6b; 6c, 6d**) for producing a test current (**I$_R$1; I$_{R2}$**) which flows through the resistance (**R1; R2**), wherein these voltage potentials (**Q$_A$, Q$_B$; Q$_A$, Q$_C$**) are selected in such a manner that the direction of flow of the test current (**I$_{R1}$; I$_{R2}$**) coincides with the direction of flow of the leakage current (**I$_{RL1}$**),

      b2) measurement of the terminal voltage (**U$_A$, U$_B$; U$_A$, U$_C$**) occurring on the terminal contacts (**6a, 6b; 6c, 6d**),

      b3) measurement of the test current (**I$_{A1}$; I$_{A2}$**) and

   c) calculating the resistance value (**R$_1$; R$_2$**) with the help of the measured values for the leakage current (**I$_{RL1}$**), the test current (**I$_{A1}$, I$_{A2}$**) and the terminal voltage (**U$_A$, U$_B$; U$_A$, U$_C$**).

2. A method according to Claim 1, **characterized in that**, prior to the determination of the leakage current (**I$_{RL1}$**), a test of the leads (**3a, 3b, 3c, 3d**) for an interruption in the leads is carried out by means of:

   a) a rectifier element (**D$_1$; D$_2$**) bridging the resistance (**R$_1$; R$_2$**),

   b) producing voltage potentials (**Q$_B$, Q$_A$'; Q$_C$, Q$_A$'**) on the terminal contacts (**6a, 6b; 6c, 6d**) in such a manner that the rectifier element (**D$_1$; D$_2$**) is made forwardly conductive,

   c) measuring the voltages (**U$_A$, U$_B$; U$_A$, U$_C$**) occurring on the terminal contacts (**6a, 6b; 6c, 6d**) and

d) evaluating the voltages ($U_A$, $U_B$; $U_A$, $U_C$) as well as their voltage differences ($U_B$ - $U_A$; $U_C$ - $U_A$);

3. A method according to Claim 2, **characterized in that** a second resistance zone (**5b**) is added to the resistive device (**4**), the first terminal contact (**6c**) of said second resistance zone being connected to the terminal contact (**6a**) of the first resistance zone (**5a**) in such a manner that the rectifier element ($D_1$) of the first resistance zone (**5a**) is connected in the same direction as the rectifier element ($D_2$) of the second resistance zone (**5b**), and **in that** a further voltage potential ($Q_C$) is connected to the second terminal contact (**6d**) of the second resistance zone.

4. A method according to any of the Claims 1 to 3, **characterized in that** voltage potentials ($Q_A$, $Q_B$, $Q_C$, $Q_A'$, $Q_B'$, $Q_C'$) differing from the reference potential are used.

5. A circuit arrangement for carrying out the method according to Claim 1 to 4, comprising the features:

   a) voltage controlled current sources (**A, B, C**), voltage controlled current sinks (**B', C**) and a transistor ($T_1$) having a protective resistor ($R_V$) which are provided for the production of the voltage potentials ($Q_A$, $Q_B$, $Q_C$, $Q_A'$, $Q_B'$, $Q_C'$),

   b) a microprocessor ($\mu$**P**) incorporating a program for carrying out the method according to Claim 1 which is provided for controlling the voltage controlled current sources (**A, B, C**) and current sinks (**B', C'**) and the transistor ($T_1$) and

   c) an A/D converter (**7'**) which is provided for the digitisation of the measured voltages ($U_A$, $U_B$, $U_C$) and the currents ($I_A$, $I_{A1}$, $I_{A2}$) and for passing on the digitised measured values to the microprocessor ($\mu$**P**).

6. Use of the circuit arrangement according to Claim 5 for the determination of the resistance value of a sensor mat (4) for detecting whether a seat is occupied in a motor vehicle.

## Revendications

1. Procédé pour déterminer la valeur résistive d'un dispositif résistif (4) constitué par au moins une zone de résistance (5a; 5b) comportant respectivement une résistance variable ($R_1$; $R_2$) comportant des lignes d'alimentation (3a, 3b; 3c, 3d), les lignes d'alimentation étant reliées respectivement à des contacts de raccordement (6a, 6b; 6c, 6d), comportant les étapes opératoires suivantes:

   a) détermination d'un courant de fuite ($I_{RL1}$) par

      a1) application de potentiels de tension ($Q_A$, $Q_B$, $Q_C$, $Q_B'$, $Q_C'$) de même valeur aux contacts de raccordement (6a, 6b; 6c, 6d),
      a2) mesure des tensions ($U_A$, $U_B$, $U_C$) qui s'établissent au niveau des points de raccordement (6a, 6b; 6c, 6d) par rapport au potentiel de référence, et évaluation de la valeur de ces tensions ($U_A$, $U_B$, $U_C$) en ce qui concerne un écart pour déterminer s'il existe un écart trop important entre elles,
      a3) mesure d'un courant de fuite ($I_{RL1}$) qui apparaît sur l'un des contacts de raccordement (6a, 6b; 6c, 6d) et évaluation de la valeur de ce courant,

   b) mesure des grandeurs nécessaire pour déterminer la valeur résistive ($R_1$; $R_2$) par

      b1) application de premier et second potentiels de tension ($Q_A$, $Q_B$; $Q_A$, $Q_C$) aux contacts de raccordement (6a, 6b; 6c, 6d) avec des amplitudes différentes de potentiel pour la production d'un courant de contrôle ($I_{R1}$; $I_{R2}$), qui circule dans la résistance ($R_1$; $R_2$), ces potentiels de tension ($Q_A$, $Q_B$; $Q_A$, $Q_C$) sont choisis de telle sorte que le sens du courant de contrôle ($I_{R2}$, $I_{R2}$) coincide avec la direction du courant de fuite ($I_{RL1}$),
      b2) mesure de la tension aux bornes ($Q_A$, $Q_B$; $Q_A$, $Q_C$) qui s'établit au niveau des contacts de raccordement (6a, 6b; 6c, 6d),
      b3) mesure du courant de contrôle ($I_{R1}$; $I_{R2}$), et

   c) calcul de la valeur résistive ($R_1$; $R_2$) à l'aide des valeurs mesures du courant de fuite ($I_{RL1}$), du courant de contrôle ($I_{A1}$; $I_{A2}$) et de la tension aux bornes ($U_A$, $U_B$; $U_A$ $U_C$).

**2.** Procédé selon la revendication 1, **caractérisé en ce qu'**avant la détermination du courant de fuite ($I_{RL1}$), on exécute un contrôle des lignes d'alimentation (3a, 3b; 3c, 3d) pour déterminer s'il existe une interruption de ligne, au moyen:

a) d'un élément redresseur ($D_1$; $D_2$) qui shunte la résistance ($R_1$; $R_2$),
b) de la production de potentiels de tension ($Q_B$, $Q_A'$; $Q_C$, $Q_A'$) au niveau des contacts de raccordement (6a, 6b; 6c, 6d) de telle sorte que l'élément redresseur ($D_1$; $D_2$) est commandé dans le sens passant,
c) de la mesure des tensions ($U_A$, $U_B$; $U_A$, $U_C$) qui s'établissent au niveau du contact de raccordement (6a, 6b; 6c, 6d), et
d) de l'évaluation des tensions ($U_A$, $U_B$; $U_A$, $U_C$) ainsi que de leurs différences ($U_B$ - $U_A$; $U_C$ - $U_A$).

**3.** Procédé selon la revendication 2, **caractérisé en ce qu'**au dispositif résistif (4) est ajoutée une seconde zone de résistance (5b), dont le premier contact de raccordement (6c) est relié au contact de raccordement (6d) de la première zone de résistance (5a), de telle sorte que l'élément redresseur ($D_1$) de la première zone de résistance (5a) possède le même sens de raccordement que l'élément redresseur ($D_2$) de la seconde zone de résistance (5b), et qu'un autre potentiel de tension ($Q_C$) est appliqué au second contact de raccordement (6d).

**4.** Procédé selon l'une des revendications 1 à 3, **caractérisé en ce qu'**on utilise des potentiels de tension ($Q_A$, $Q_B$, $Q_C$, $Q_A'$, $Q_B'$, $Q_C'$), qui diffèrent du potentiel de référence.

**5.** Montage pour la mise en oeuvre du procédé selon les revendications 1 à 4, présentant les caractéristiques:

a) pour la production des potentiels de tension ($Q_A$, $Q_B$, $Q_C$, $Q_A'$, $Q_B'$, $Q_C'$), il est prévu des sources de courant (A, B, C) commandées par la tension, des puits de courant (B', C') commandés par la tension et un transistor ($T_1$) comportant une résistance additionnelle ($R_V$),
b) pour la commande des sources de courant (A, B, C) commandées par la tension et des puits de courant (B', C') commandés par la tension et du transistor ($T_1$), il est prévu un microprocesseur ($\mu P$) comportant un programme pour la mise en oeuvre du procédé selon la revendication 1, et
c) pour la numérisation des tensions mesurées ($U_A$, $U_B$, $U_C$) et des courants mesurés ($I_A$, $I_{A1}$, $I_{A2}$) et pour le transfert des valeurs de mesure numérisées au microprocesseur ($\mu P$), il est prévu un convertisseur analogique/ numérique (7').

**6.** Utilisation du montage selon la revendication 5, pour déterminer la valeur résistive d'un mat de capteur (4) pour identifier l'occupation d'un siège dans un véhicule automobile.

1. PRÜFUNGSTEIL
PHASE 1 (+2)

2. PRÜFUNGSTEIL
PHASE 3

3. PRÜFUNGSTEIL
PHASE 4 (+5)

PHASE 6

**START**

ÜBERPRÜFEN DER ZULEITUNG(EN)

UNTERBRECHUNG ODER KURZSCHLUSS? — JA

NEIN

LECKSTROM DER ZULEITUNGEN MESSEN

LECKSTROM ZU GROSS ? — JA

NEIN

WIDERSTAND DER SITZBELEGUNGS-SCHALTUNG(EN) BESTIMMEN

$< 500\ k\Omega$ $(< 50\ k\Omega)$ — JA — SITZ BELEGT

NEIN

SITZ NICHT BELEGT

**ENDE**

ERGEBNIS DER AIR-BAG-STEUEREINHEIT MITTEILEN

**FIG. 1a**

START

ZUSTAND 2

SPANNUNG $U_B$ MESSEN

$U_B < 18V$ — JA → QUELLE B DEFEKT ODER LECKWIDERSTAND $R_{L2}$ ZU KLEIN

NEIN

SPANNUNG $U_A$ MESSEN

$U_B - U_A > 5V$ — JA → LEITUNGS-UNTERBRECHUNG

NEIN

ZUSTAND 3

SPANNUNG $U_C$ MESSEN

$U_C < 18V$ — JA → QUELLE C DEFEKT ODER LECKWIDERSTAND $R_{L3}$ ZU KLEIN

NEIN

SPANNUNG $U_A$ MESSEN

$U_C - U_A > 5V$ — JA → LEITUNGS-UNTERBRECHUNG

NEIN

U

V

FIG.1b

12

FIG.1b

W

ZUSTAND 5

SPANNUNG $U_A$ MESSEN

SPANNUNG $U_B$ MESSEN

STROM $I_{A1}$ MESSEN

$I_{R1} = I_{A1} - I_{RL1}$

BERECHNEN:
$R_1 = ( U_A - U_B ) : I_{R1}$

$R_1 < 50$ kOHM

NEIN

JA

SENSORZONE 5a
BESETZT

SENSORZONE 5a
NICHT BESETZT

Y

X

Z

FIG.1b

```
                          Y                                    Z
                    ┌──────────────┐
                    │  ZUSTAND  6  │
                    └──────────────┘
                           │
              ┌─────────────────────────┐
              │  SPANNUNG  U_A   MESSEN  │
              └─────────────────────────┘
                           │
              ┌─────────────────────────┐
              │  SPANNUNG  U_C   MESSEN  │
              └─────────────────────────┘
                           │
              ┌─────────────────────────┐
              │  STROM  I_A2    MESSEN   │
              └─────────────────────────┘
                           │
              ┌─────────────────────────┐
              │  I_R2 = I_A2 − I_RL1     │
              └─────────────────────────┘
                           │
              ┌─────────────────────────┐
              │  BERECHNEN:              │
              │  R_2 = ( U_A −U_C ):I_R2 │
              └─────────────────────────┘
                           │
                       ╱───────────╲              ┌──────────────────┐
                      ╱  R_2 < 50    ╲     JA      │  SENSORZONE  5b   │
                      ╲   kOHM       ╱─────────────▶│   BESETZT        │────▶
                       ╲───────────╱               └──────────────────┘
                          │ NEIN
              ┌──────────────────┐
              │  SENSORZONE  5b   │
              │  NICHT BESETZT    │
              └──────────────────┘
                           │◀──────────────────────────────────┘
              ┌──────────────────┐
              │   ZUSTAND  1      │
              └──────────────────┘
                           │
                    ╱──────────╲
                   /   ENDE     /
                   ──────────────
```

$$I_{R2} = I_{A2} - I_{RL1}$$

BERECHNEN:
$$R_2 = ( U_A - U_C ):I_{R2}$$

$R_2 < 50$ kOHM

# FIG.1b

ZUSTAND 1

FIG.2

ZUSTAND 2

FIG.3

EP 0 791 834 B1

FIG. 4

ZUSTAND 4

FIG.5

EP 0 791 834 B1

ZUSTAND 5

FIG.6

EP 0 791 834 B1

ZUSTAND 6

FIG.7